# EUROPEAN PATENT APPLICATION

(11) **EP 2 151 864 A2**
(43) Date of publication of application: **10.02.2010**
(21) Application number: 09009738.7
(22) Date of filing: 28.07.2009
(51) Int. Cl.: H01L 25/00, H01L 23/66, H01Q 1/24, H01Q 9/04

(54) **IC having in-trace antenna elements**

(30) Priority: 07.08.2008 US 188060
(71) Applicant: Broadcom Corporation, Irvine, CA 92617 (US)
(72) Inventor: Rofougaran, Ahmadreza, 92657 Newport Coast, CA (US)
(74) Representative: Jehle, Volker Armin

(57) **Abstract**

An integrated circuit (10) includes a circuit block (12), a millimeter wave (MMW) front-end (14), and a connection module (15). The connection module includes first and second frequency dependent impedance modules (16 and 18) and first and second trace sections (20 and 22). The first trace section (20) provides an antenna segment for the MMW front-end (14) and the series combination of the first and second frequency dependent impedance modules (16 and 18) and the first and second trace sections (20 and 22) provides a connection for the circuit block (12).

## Description

### BACKGROUND OF THE INVENTION

### TECHNICAL FIELD OF THE INVENTION

This invention relates generally to wireless communication and more particularly to integrated circuits used to support wireless communications.

### DESCRIPTION OF RELATED ART

Communication systems are known to support wireless and wire lined communications between wireless and/or wire lined communication devices. Such communication systems range from national and/or international cellular telephone systems to the Internet to point-to-point in-home wireless networks to radio frequency identification (RFID) systems. Each type of communication system is constructed, and hence operates, in accordance with one or more communication standards. For instance, wireless communication systems may operate in accordance with one or more standards including, but not limited to, RFID, IEEE 802.11, Bluetooth, advanced mobile phone services (AMPS), digital AMPS, global system for mobile communications (GSM), code division multiple access (CDMA), local multi-point distribution systems (LMDS), multichannel-multi-point distribution systems (MMDS), and/or variations thereof.

Depending on the type of wireless communication system, a wireless communication device, such as a cellular telephone, two-way radio, personal digital assistant (PDA), personal computer (PC), laptop computer, home entertainment equipment, RFID reader, RFID tag, et cetera communicates directly or indirectly with other wireless communication devices. For direct communications (also known as point-to-point communications), the participating wireless communication devices tune their receivers and transmitters to the same channel or channels (e.g., one of the plurality of radio frequency (RF) carriers of the wireless communication system) and communicate over that channel(s). For indirect wireless communications, each wireless communication device communicates directly with an associated base station (e.g., for cellular services) and/or an associated access point (e.g., for an in-home or in-building wireless network) via an assigned channel. To complete a communication connection between the wireless communication devices, the associated base stations and/or associated access points communicate with each other directly, via a system controller, via the public switch telephone network, via the Internet, and/or via some other wide area network.

For each wireless communication device to participate in wireless communications, it includes a built-in radio transceiver (i.e., receiver and transmitter) or is coupled to an associated radio transceiver (e.g., a station for in-home and/or in-building wireless communication networks, RF modem, etc.). As is known, the receiver is coupled to the antenna and includes a low noise amplifier, one or more intermediate frequency stages, a filtering stage, and a data recovery stage. The low noise amplifier receives inbound RF signals via the antenna and amplifies then. The one or more intermediate frequency stages mix the amplified RF signals with one or more local oscillations to convert the amplified RF signal into baseband signals or intermediate frequency (IF) signals. The filtering stage filters the baseband signals or the IF signals to attenuate unwanted out of band signals to produce filtered signals. The data recovery stage recovers raw data from the filtered signals in accordance with the particular wireless communication standard.

As is also known, the transmitter includes a data modulation stage, one or more intermediate frequency stages, and a power amplifier. The data modulation stage converts raw data into baseband signals in accordance with a particular wireless communication standard. The one or more intermediate frequency stages mix the baseband signals with one or more local oscillations to produce RF signals. The power amplifier amplifies the RF signals prior to transmission via an antenna.

Currently, wireless communications occur within licensed or unlicensed frequency spectrums. For example, wireless local area network (WLAN) communications occur within the unlicensed Industrial, Scientific, and Medical (ISM) frequency spectrum of 900 MHz, 2.4 GHz, and 5 GHz. While the ISM frequency spectrum is unlicensed there are restrictions on power, modulation techniques, and antenna gain. Another example of an unlicensed frequency spectrum is the V-band of 55-64 GHz.

Since the wireless part of a wireless communication begins and ends with the antenna, a properly designed antenna structure is an important component of wireless communication devices. As is known, the antenna structure is designed to have a desired impedance (e.g., 50 Ohms) at an operating frequency, a desired bandwidth centered at the desired operating frequency, and a desired length (e.g., ¼ wavelength of the operating frequency for a monopole antenna). As is further known, the antenna structure may include a single monopole or dipole antenna, a diversity antenna structure, the same polarization, different polarization, and/or any number of other electro-magnetic properties.

One popular antenna structure for RF transceivers is a three-dimensional in-air helix antenna, which resembles an expanded spring. The in-air helix antenna provides a magnetic omni-directional mono pole antenna. Other types of three-dimensional antennas include aperture antennas of a rectangular shape, horn shaped, etc,; three-dimensional dipole antennas having a conical shape, a cylinder shape, an elliptical shape, etc.; and reflector antennas having a plane reflector, a corner reflector, or a parabolic reflector. An issue with such three-dimensional antennas is that they cannot be implemented in the substantially two-dimensional space of an integrated circuit (IC) and/or on the printed circuit board (PCB) supporting the IC.

Two-dimensional antennas are known to include a meandering pattern or a micro strip configuration. For efficient antenna operation, the length of an antenna should be ¼ wavelength for a monopole antenna and ½ wavelength for a dipole antenna, where the wavelength (λ) = c/f, where c is the speed of light and f is frequency. For example, a ¼ wavelength antenna at 900 MHz has a total length of approximately 8.3 centimeters (i.e., 0.25 * (3x10⁸ m/s)/(900x10⁶ c/s) = 0.25*33 cm, where m/s is meters per second and c/s is cycles per second). As another example, a ¼ wavelength antenna at 2400 MHz has a total length of approximately 3.1 cm (i.e., 0.25 * (3x10⁸ m/s)/(2.4x10⁹ c/s) = 0.25*12.5 cm). As such, due to the antenna size, it cannot be implemented on-chip since a relatively complex IC having millions of transistors has a size of 2 to 20 millimeters by 2 to 20 millimeters.

As IC fabrication technology continues to advance, ICs will become smaller and smaller with more and more transistors. While this advancement allows for reduction in size of electronic devices, it does present a design challenge of providing and receiving signals, data, clock signals, operational instructions, etc., to and from a plurality of ICs of the device. Currently, this is addressed by improvements in IC packaging and multiple layer PCBs. For example, ICs may include a ball-grid array of 100 - 200 pins in a small space (e.g., 2 to 20 millimeters by 2 to 20 millimeters). A multiple layer PCB includes traces for each one of the pins of the IC to route to at least one other component on the PCB. Clearly, advancements in communication between ICs is needed to adequately support the forth-coming improvements in IC fabrication.

Therefore, a need exists for an integrated circuit antenna structure and wireless communication applications thereof.

### BRIEF SUMMARY OF THE INVENTION

The present invention is directed to apparatus and methods of operation that are further described in the following Brief Description of the Drawings, the Detailed Description of the Invention, and the claims.

According to an aspect, an integrated circuit (IC) comprises:
a circuit block;
a millimeter wave (MMW) front-end; and
a connection module coupled to the circuit block and to the MMW front-end, wherein the connection module includes:
   a first frequency dependent impedance module;
   a second frequency dependent impedance module;
   a first trace section coupled between the first and second frequency dependent impedance modules, wherein the first trace section provides an antenna segment for the MMW front-end; and
   a second trace section coupled between the second frequency dependent impedance module and the circuit block, wherein a series combination of the first and second frequency dependent impedance modules and the first and second trace sections provides a connection for the circuit block.

Advantageously, the IC further comprises:
a die, wherein the circuit block, the MMW front-end, and the connection module are implemented on the die.

Advantageously, the IC further comprises:
a die, wherein the circuit block and the MMW front-end are implemented on the die; and
a package substrate that supports the die, wherein a portion of the connection module is implemented on the package substrate and a remaining portion of the connection module is implemented on the die.

Advantageously, the IC further comprises:
a second circuit block, wherein the connection module couples the circuit block to the second circuit block.

Advantageously, the circuit block is operable to receive or transmit a data signal via the connection module.

Advantageously, the circuit block is coupled to a power supply source or a power supply return via the connection module.

Advantageously, the IC further comprises:
a third frequency dependent impedance module; and
a third trace section coupled between the first and third frequency dependent impedance modules, wherein the third trace section provides a second antenna segment for the MMW front-end, wherein the antenna segment and the second antenna segment form a dipole antenna.

Advantageously, each of the first and second frequency dependent impedance modules comprises at least one of:
an inductor;
an inductor and a capacitor;
an inductor and an inductor-capacitor tank circuit; and
an inductor and a low pass filter.

Advantageously, the IC further comprises:
a ground plane proximal to first trace section such that the first trace section provides a monopole antenna for the MMW front-end.

According to an aspect, an integrated circuit (IC) comprises:
a circuit block;
a millimeter wave (MMW) front-end;
a first connection module including:
   a first frequency dependent impedance module;
   a second frequency dependent impedance module;
   a first trace section coupled between the first and second frequency dependent impedance modules, wherein the first trace section provides an antenna segment for the MMW front-end; and
   a second trace section coupled between the second frequency dependent impedance module and the circuit block, wherein the series combination of the first and second frequency dependent impedance modules and the first and second trace sections provides a first connection for the circuit block; and
a second connection module including:
   a third frequency dependent impedance module;
   a fourth frequency dependent impedance module;
   a third trace section coupled between the third and fourth frequency dependent impedance modules, wherein the third trace section provides a second antenna segment for the MMW front-end; and
   a fourth trace section coupled between the fourth frequency dependent impedance module and the circuit block, wherein the series combination of the third and fourth frequency dependent impedance modules and the third and fourth trace sections provides a second connection for the circuit block; and
a high frequency connecting module coupled to the first trace section and the third trace section such that the first and second antenna segments are operably connected together in a frequency range corresponding to an operational frequency of the MMW front-end.

Advantageously, the high frequency connection module comprises:
a series inductor-capacitor tank circuit.

Advantageously, the IC further comprises:
a third connection module including:
   a fifth frequency dependent impedance module;
   a sixth frequency dependent impedance module;
   a fifth trace section coupled between the fifth and sixth frequency dependent impedance modules, wherein the fifth trace section provides a third antenna segment for the MMW front-end; and
   a sixth trace section coupled between the sixth frequency dependent impedance module and the circuit block, wherein the series combination of the fifth and sixth frequency dependent impedance modules and the fifth and sixth trace sections provides a third connection for the circuit block; and
a second high frequency connecting module coupled to the third trace section and the fifth trace section such that the first, second, and third antenna segments are operably connected together in a frequency range corresponding to an operational frequency of the MMW front-end.

Advantageously, the IC further comprises:
an antenna coupling circuit that includes:
   a transmission line coupled the first or third antenna segment; and
   a transformer coupled to the transmission line.

Advantageously, the antenna coupling circuit further comprises:
an impedance matching circuit coupled to the transformer.

According to a further aspect, an integrated circuit (IC) comprises:
a plurality of frequency dependent impedance modules; and
a plurality of trace sections, wherein a first trace section of the plurality of trace sections is coupled between a first and a second frequency dependent impedance module of the plurality of frequency dependent impedance modules, wherein the first trace section provides an antenna segment; and
wherein a second trace section of the plurality of trace sections is coupled to the second frequency dependent impedance module, wherein a series combination of the first and
second frequency dependent impedance modules and the first and second trace sections provides a connection.

Advantageously, the IC further comprises:
a third trace section of the plurality of trace sections is coupled between the second and a third frequency dependent impedance module of the plurality of frequency dependent impedance modules, wherein the third trace section provides a second antenna segment; and
a fourth trace section of the plurality of trace sections is coupled to the third frequency dependent impedance module, wherein a series combination of the first, second, and third frequency dependent impedance modules and the first, second, third, and fourth trace sections provides the connection.

Advantageously, the IC further comprises:
a third trace section of the plurality of trace sections is coupled between a third and a fourth frequency dependent impedance module of the plurality of frequency dependent impedance modules, wherein the third trace section provides a second antenna segment; and
a fourth trace section of the plurality of trace sections is coupled to the fourth frequency dependent impedance module, wherein a series combination of the third and fourth frequency dependent impedance modules and the third and fourth trace sections provides a second connection.

Advantageously, the IC further comprises:
a high frequency connecting module coupling the antenna segment to the second antenna segment.

Other features and advantages of the present invention will become apparent from the following detailed description of the invention made with reference to the accompanying drawings.

### BRIEF DESCRIPTION OF THE SEVERAL VIEWS OF THE DRAWING(S)

Figure 1 is a schematic block diagram of an embodiment of an integrated circuit in accordance with the present invention;
Figure 2 is a schematic block diagram of another embodiment of an integrated circuit in accordance with the present invention;
Figure 3 is a schematic block diagram of another embodiment of an integrated circuit in accordance with the present invention;
Figure 4 is a schematic block diagram of another embodiment of an integrated circuit in accordance with the present invention;
Figure 5 is a schematic block diagram of another embodiment of an integrated circuit in accordance with the present invention;
Figure 6 is a schematic block diagram of an embodiment of a connection module and an embodiment of a MMW front-end in accordance with the present invention;
Figure 7 is a schematic block diagram of another embodiment of a connection module and another embodiment of a MMW front-end in accordance with the present invention;
Figure 8 is a schematic block diagram of another embodiment of a connection module coupled to a MMW front-end and a circuit block in accordance with the present invention;
Figure 9 is a schematic block diagram of another embodiment of a connection module coupled to a MMW front-end and two circuit blocks in accordance with the present invention;
Figure 10 is a schematic block diagram of another embodiment of a connection module coupled to a MMW front-end and two circuit blocks in accordance with the present invention;
Figure 11 is a schematic block diagram of another embodiment of a connection module coupled to a MMW front-end and a circuit block in accordance with the present invention;
Figure 12 is a schematic block diagram of another embodiment of an integrated circuit in accordance with the present invention;
Figure 13 is a schematic block diagram of another embodiment of an integrated circuit in accordance with the present invention;
Figure 14 is a schematic block diagram of another embodiment of an integrated circuit in accordance with the present invention;
Figure 15 is a schematic block diagram of an embodiment of two connection modules and an embodiment of a high frequency connection module in accordance with the present invention;
Figure 16 is a schematic block diagram of an embodiment of coupling a connection module to a MMW front-end in accordance with the present invention;
Figure 17 is a schematic block diagram of another embodiment of coupling a connection module to a MMW front-end in accordance with the present invention; and
Figure 18 is a schematic block diagram of another embodiment of coupling a connection module to a MMW front-end in accordance with the present invention.

### DETAILED DESCRIPTION OF THE INVENTION

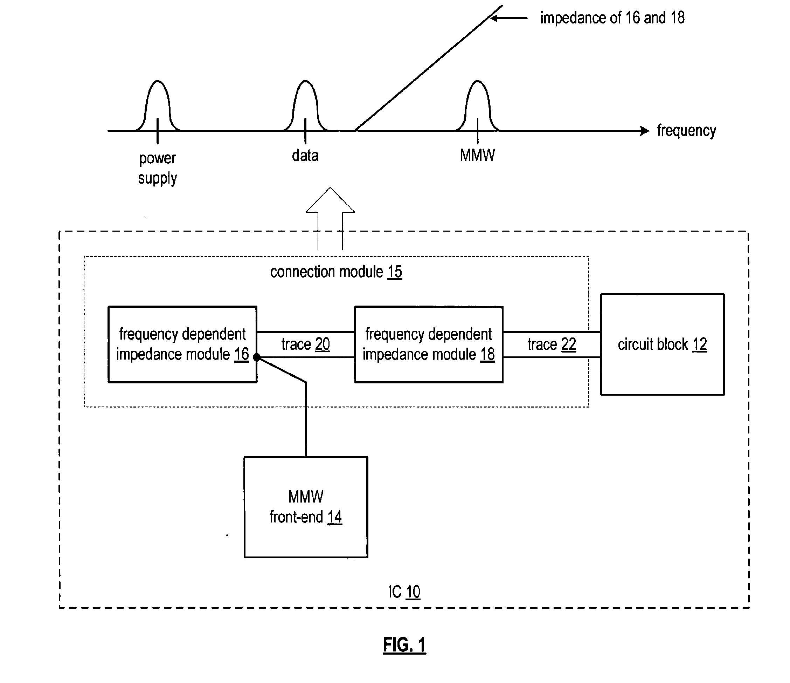

Figure 1 is a schematic block diagram of an embodiment of an integrated circuit (IC) 10 that includes a circuit block 12, a millimeter wave (MMW) front-end 14, and a connection module 15. The connection module 15 includes first and second frequency dependent impedance modules 16 and 18 and first and second trace sections 20 and 22. The IC 10 may be implemented using any one of a plurality of IC fabrication techniques including, but not limited to, CMOS (complimentary metal oxide semiconductor), bi-CMOS, Gallium Arsenide, Silicon Germanium, etc. having one or more metal layers.

In this embodiment, the first trace section 20 (e.g., a metal trace on one or more metal layers of the IC 10) provides an antenna segment for the MMW front-end 14. In addition, the series combination of the first and second frequency dependent impedance modules 16 and 18 and the first and second trace sections 20 and 22 provides a connection for the circuit block 12. To achieve this, the first and second frequency dependent impedance modules 16 and 18 contain high frequency signals (e.g., MMW frequency (3 GH to 300 GHz) inbound and/or output signals received and/or transmitted via the MMW front-end 14) therebetween and pass lower frequency signals (e.g., data signals transmitted from or received by the circuit block 12 or power supply lines) with minimal to no attenuation.

As an example and with reference to the frequency diagram of Figure 1, assume that the circuit block 12 is a memory block, a digital circuit, an analog circuit, a logic circuit, a processing block, or any other type of circuit that receives and/or transmits signals via the connection module 15. Further assume that the rate of the signals is between 100 KHz and 1 GHz and the MMW front-end 14 transmits and/or receives signals in the 60GHz frequency band. In this example, the frequency dependent impedance modules 16 and 18 have a low impedance at frequencies in the 100 KHz to 1 GHz range, which allows the data signals to pass with little or no attenuation. In addition, the frequency dependent impedance modules 16 and 18 have a high impedance in the 60 GHz range, which substantially contains the 60 GHz signals transmitted and/or received by the MMW front end between the modules 16 and 18.

As another example, assume that the connection module 15 provides the power supply connection and/or power supply return connection for the circuit block 12. In the frequency diagram of Figure 1, the power supply frequency is lower than that of the data, as such, the impedance of the frequency dependent impedance modules 16 and 18 is very low and has little to no affect on the powering of the circuit block 12 and yet provides an on IC antenna segment for the MMW front-end 14. Note that the antenna segment may be used as a ½ wavelength or ¼ wavelength meandering type antenna, a monopole antenna, a whip antenna, and/or any other type of microstrip antenna. Further note that the antenna segment may be used in combination with other antenna segments to form an antenna (e.g., a dipole antenna, helical antenna, etc.) and/or may used with other antenna segments to form an antenna array.

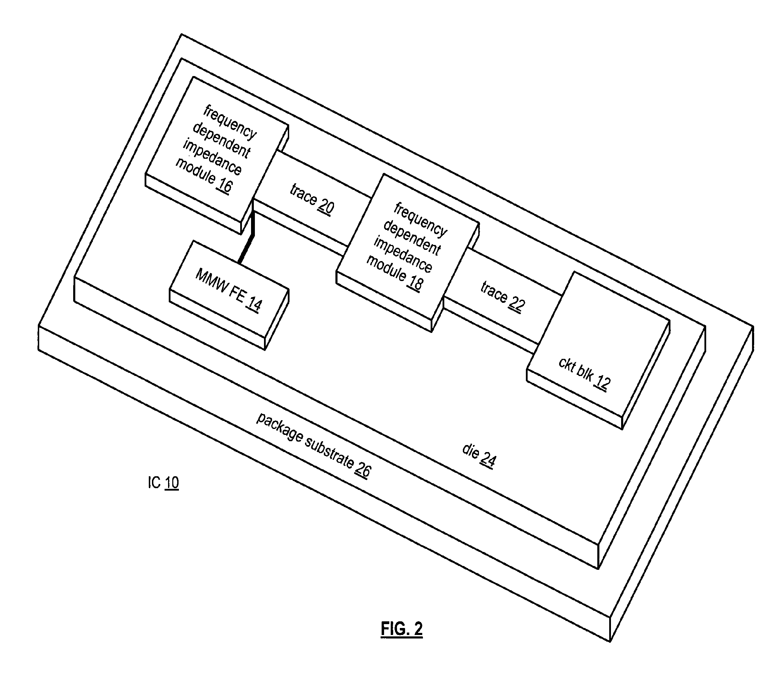

Figure 2 is a schematic block diagram of another embodiment of an integrated circuit 10 that includes a die 24 and a package substrate 26. In this embodiment, the die 24 supports the circuit block 12, the MMW front-end 14, the frequency dependent impedance modules 16 and 18, and the first and second trace sections 20 and 22. The package substrate supports 26 the die 24. As an example, the die 24 may be fabricated using complimentary metal oxide semiconductor (CMOS) technology and the package substrate 26 may be a printed circuit board (PCB). As other examples, the die 24 may be fabricated using Gallium-Arsenide technology, Silicon-Germanium technology, bi-polar technology, bi-CMOS technology, and/or any other type of IC fabrication technique and the package substrate 26 may be a printed circuit board (PCB), a fiberglass board, a plastic board, and/or some other non-conductive material board. Note that the package substrate 26 may function as a supporting structure for the die 24 and contain little or no traces.

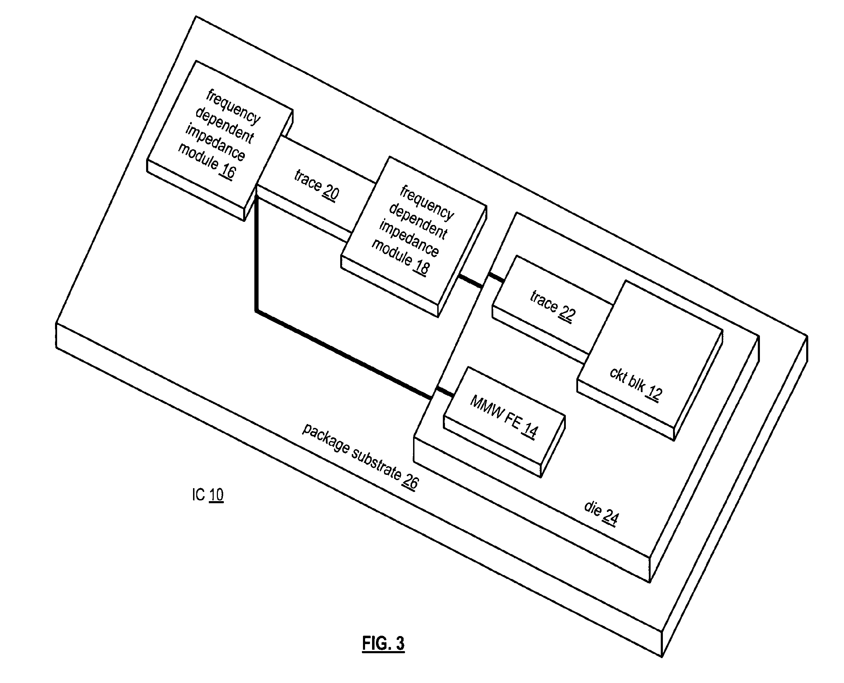

Figure 3 is a schematic block diagram of another embodiment of an integrated circuit 10 that includes a die 24 and a package substrate 26. In this embodiment, the die 24 supports the circuit block 12, the MMW front-end 14 and the second trace section 22. The package substrate supports the die 24, the frequency dependent impedance modules 16 and 18, and the first trace section 20 and 22.

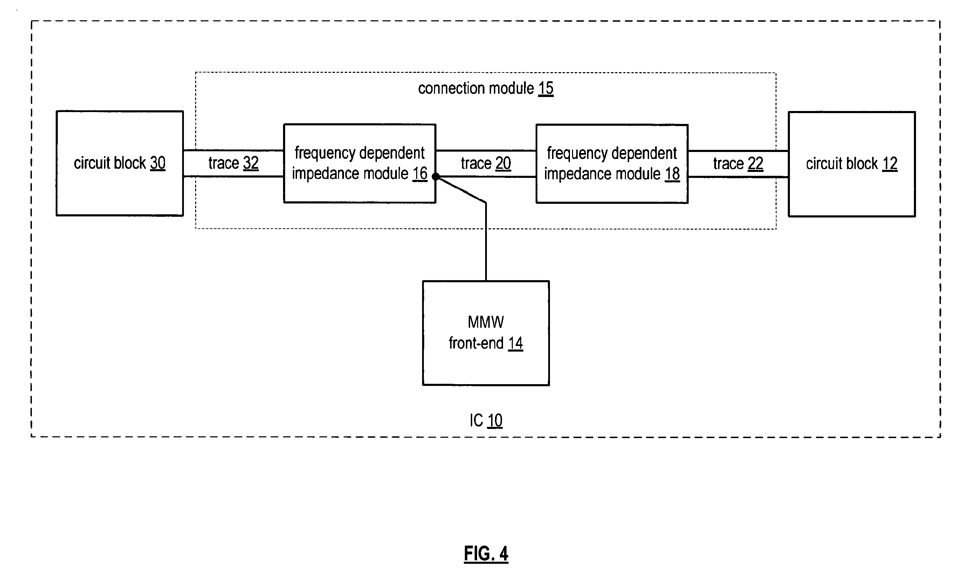

Figure 4 is a schematic block diagram of another embodiment of an integrated circuit 10 that includes the circuit block 12, the millimeter wave (MMW) front-end 14, the connection module 15, and a second circuit block 30. The connection module 15 includes first and second frequency dependent impedance modules 16 and 18 and first, second, and third trace sections 20, 22, and 32.

In this embodiment, the first trace section 20 (e.g., a metal trace on one or more metal layers of the IC 10) provides an antenna segment for the MMW front-end 14. In addition, the series combination of the first and second frequency dependent impedance modules 16 and 18 and the first, second, and third trace sections 20, 22, and 32 provides a connection between the circuit block 12 and the second circuit block 30 (which may be a memory block, a digital circuit, an analog circuit, a logic circuit, a processing block, or any other type of circuit that receives and/or transmits signals). To achieve this, the first and second frequency dependent impedance modules 16 and 18 contain high frequency signals (e.g., MMW frequency inbound and/or output signals received and/or transmitted via the MMW front-end 14) therebetween and pass lower frequency signals (e.g., data signals transmitted between the circuit block 12 and the second circuit block 30) with minimal to no attenuation.

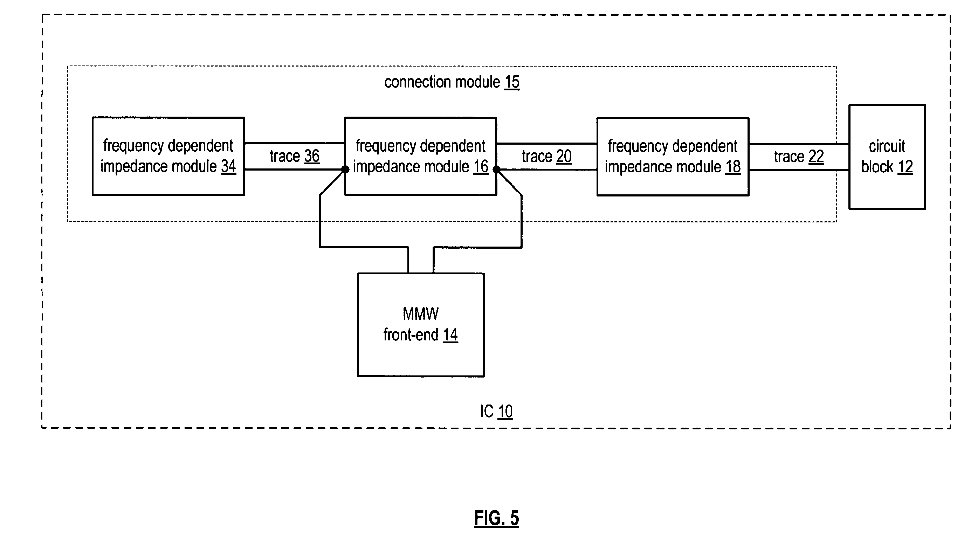

Figure 5 is a schematic block diagram of another embodiment of an integrated circuit 10 that includes the circuit block 12, the millimeter wave (MMW) front-end 14, and the connection module 15. The connection module 15 includes first, second and third frequency dependent impedance modules 16, 18 and 34 and first, second, and third trace sections 20, 22, and 36.

In this embodiment, the first trace section 20 and the third trace section 32 provide antenna segments for the MMW front-end 14. The antenna segments may operate as a dipole antenna, may operate as separate transmit and receive antennas, may operate as diversity antennas, or may operate as an antenna array. In addition, the series combination of the first, second, and third frequency dependent impedance modules 16, 18, and 34 and the first, second, and third trace sections 20, 22, and 36 provides a connection to the circuit block 12. To achieve this, the first and second frequency dependent impedance modules 16 and 18 contain high frequency signals (e.g., MMW frequency inbound and/or output signals received and/or transmitted via the MMW front-end 14) therebetween, the first and third frequency dependent impedance modules 16 and 34 contain high frequency signals therebetween, and the frequency dependent impedance modules 16, 18, and 34 pass lower frequency signals (e.g., data signals transmitted from or received by the circuit block 12) with minimal to no attenuation.

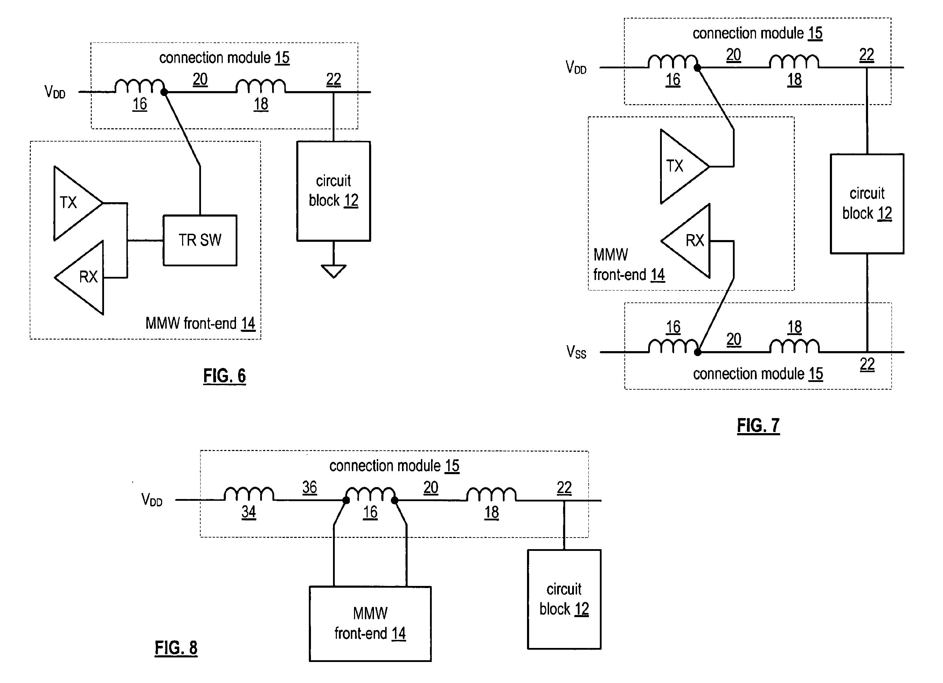

Figure 6 is a schematic block diagram of an embodiment of a connection module 15 and an embodiment of a MMW front-end 14. As shown, the MMW front-end 14 may include a transmitter section (TX), a receiver section (RX), and transmit/receive switch (TR SW). The transmitter section TX may include an up-conversion module that converts an outbound baseband signal into an outbound MMW signal and a power amplifier module (e.g., one or more power amplifier drivers coupled in parallel and/or in series and one or more power amplifiers coupled in parallel and/or series). The receiver section (RX) may include a low noise amplifier module (e.g., one or more low noise amplifiers coupled in series and/or in parallel) and a down conversion module coupled to convert an amplified inbound MMW signal into an inbound baseband signal. The IC 10 may further include a baseband processing module that converts outbound data into the outbound baseband signal and converts the inbound baseband signal into inbound data in accordance with one or more wireless communication protocols and/or standards.

The first and second frequency dependent impedance modules 16 and 18 may be implemented as inductors. Each inductor 16 and 18 has an inductance such that it has a low impedance at frequencies of the signal conveyed via the connection module 15 and has a high impedance at frequencies of signals transmitted and/or received by the MMW front-end 14, where the low impedance is much less than the high impedance (e.g., a factor of 20 dB or more). The particular inductance values depends on the frequency of the signals and the input and output impedance of the circuit block 12. For example, the inductance value (L) of the inductors 16 and 18 can be determined based on the operating frequency of the MMW front-end 14 (e.g., F_{MMW}), the frequency of the signal (e.g., F_{SIG}) to/from the circuit block 12, and the input impedance of the circuit block 12 (R_{CB}). If, at the MMW frequencies it is desired to have 100 dB attenuation with respect to F_{SIG}, then 2R_{L} = 100,000*R_{CB}. Given (inductor impedance) R_{L} = 2πF*L, the equations can be rearranged such that L = (50,000*R_{CB})/2πF_{WWM} when FSIG is 0 Hz (e.g., DC power supply line).

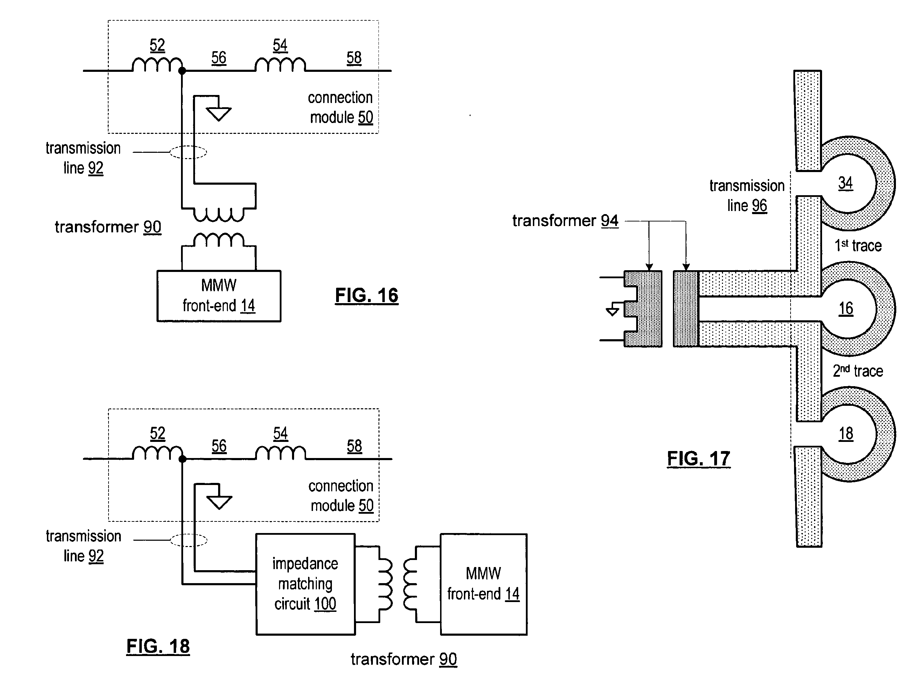

In this embodiment, the first trace section 20 provides an antenna segment for the MMW front-end 14. In addition, the series combination of the first and second frequency dependent impedance modules 16 and 18 and the first and second trace sections 20 and 22 provides the power supply (VDD) line connection for the circuit block 12. As shown, the transmit receive switch (TR SW) of the MMW front-end 14 is coupled to one end of the first trace section 20. Figures 16-18 illustrate various embodiments for coupling the MMW front-end 14 to the trace section, or sections, forming the antenna segment(s).

Figure 7 is a schematic block diagram of another embodiment of a connection module 15 and an embodiment of a MMW front-end 14. As shown, the MMW front-end 14 may include a transmitter section (TX) and a receiver section (RX) and the connection module includes two similar sections (e.g., one in the power supply line V_{DD} and another in the power supply return V_{SS}). The transmitter section TX may include an up-conversion module that converts an outbound baseband signal into an outbound MMW signal and a power amplifier module. The receiver section (RX) may include a low noise amplifier module and a down conversion module coupled to convert an amplified inbound MMW signal into an inbound baseband signal. The IC 10 may further include a baseband processing module that converts outbound data into the outbound baseband signal and converts the inbound baseband signal into inbound data in accordance with one or more wireless communication protocols and/or standards.

The first and second frequency dependent impedance modules 16 and 18 in each connection module may be implemented as inductors. Each inductor 16 and 18 has an inductance such that it has a low impedance at frequencies of the signal conveyed via the connection module 15 and has a high impedance at frequencies of signals transmitted and/or received by the MMW front-end 14, where the low impedance is much less than the high impedance (e.g., a factor of 20 dB or more).

In this embodiment, the first trace section 20 in each connection module 15 provides an antenna segment for the MMW front-end 14. In addition, the series combination of the first and second frequency dependent impedance modules 16 and 18 and the first and second trace sections 20 and 22 in each connection module provides the power supply (VDD) line and power supply return VSS connections for the circuit block 12.

Figure 8 is a schematic block diagram of another embodiment of a connection module 15 coupled to a MMW front-end 14 and a circuit block 12. The connection module 15 provides the power supply connection VDD and includes three frequency dependent impedances modules 34, 16, and 18 implemented as inductors and three trace sections 36, 20, and 22. In this embodiment, trace sections 36 and 20 provide antenna segments for the MMW front-end 14, wherein the antenna segments may provide a dipole antenna.

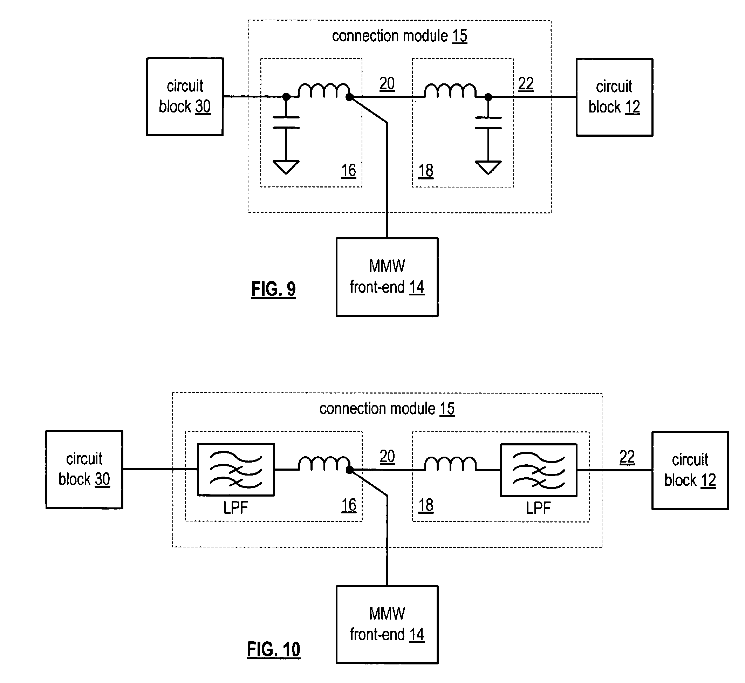

Figure 9 is a schematic block diagram of another embodiment of a connection module 15 coupled to a MMW front-end 14 and two circuit blocks 12 and 30. The connection module includes first and second frequency dependent impedance modules 16 and 18 and first and second trace sections 20 and 22. Each of the frequency dependent impedance modules includes an inductor and a capacitor. The inductor has an inductance value to provide a high impedance for the MMW signals transmitted and/or received by the MMW front-end and to provide a relatively low impedance for the signals conveyed between the circuit blocks 12 and 30. The capacitors are sized to further attenuate the high frequency signals transmitted or received by the MMW front-end 14 and to provide little or no attenuation of the signals transmitted between the circuit blocks.

Figure 10 is a schematic block diagram of another embodiment of a connection module 15 coupled to a MMW front-end 14 and two circuit blocks 12 and 30. The connection module includes first and second frequency dependent impedance modules 16 and 18 and first and second trace sections 20 and 22. Each of the frequency dependent impedance modules includes an inductor and a low pass filter (LPF). The inductor has an inductance value to provide a high impedance for the MMW signals transmitted and/or received by the MMW front-end and to provide a relatively low impedance for the signals conveyed between the circuit blocks 12 and 30. The low pass filters have a corner frequency to further attenuate the high frequency signals transmitted or received by the MMW front-end 14 and to provide little or no attenuation of the signals transmitted between the circuit blocks.

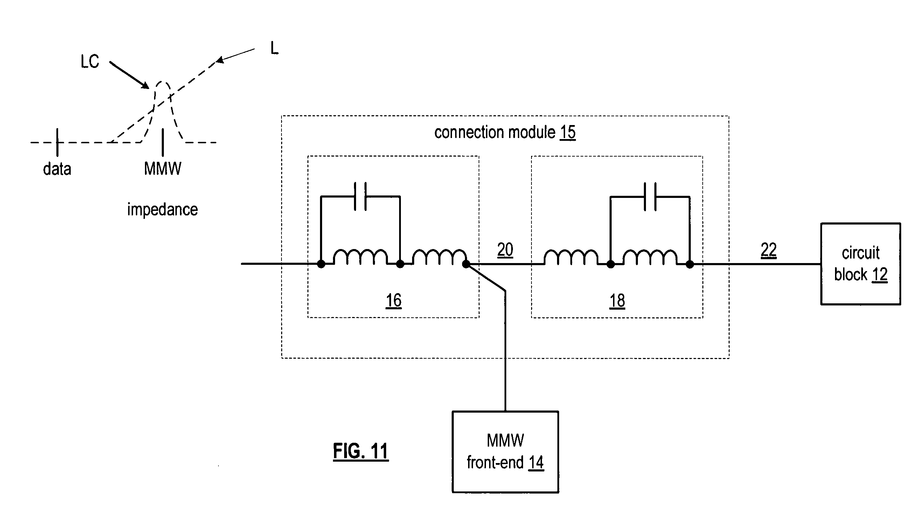

Figure 11 is a schematic block diagram of another embodiment of a connection module 15 coupled to a MMW front-end 14 and two circuit blocks 12 and 30. The connection module includes first and second frequency dependent impedance modules 16 and 18 and first and second trace sections 20 and 22. Each of the frequency dependent impedance modules includes an inductor and a parallel inductor-capacitor tank circuit. The inductor has an inductance value to provide a high impedance for the MMW signals transmitted and/or received by the MMW front-end and to provide a relatively low impedance for the signals conveyed between the circuit blocks 12 and 30. The parallel inductor-capacitor tank circuit has a resonant frequency at the high frequency signals transmitted or received by the MMW front-end 14 to produce further attenuation of these signals and to provide little or no attenuation of the signals transmitted between the circuit blocks.

The figure further includes a graphic example of the impedances of the inductor and of the parallel inductor-capacitor tank circuit. In some instances, the inductance provided by the inductors may not provide the desired level of impedance, especially for a high impedance input of the circuit block. To provide additional attenuation, the parallel inductor-capacitor (LC) tank circuit has a resonant frequency corresponding to the MMW frequency of the front-end 14. As such, at the MMW frequency range, the impedance is increased to provide the desired level of impedance.

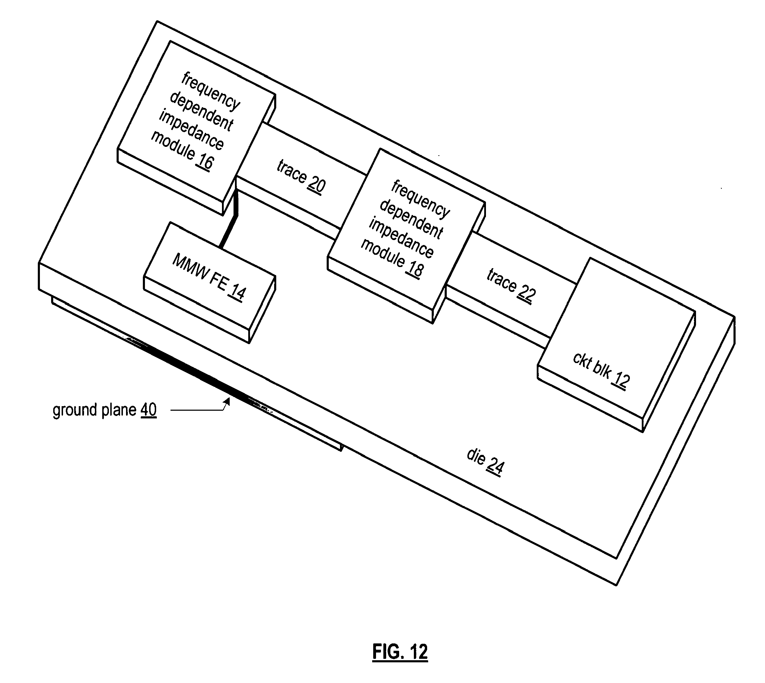

Figure 12 is a schematic block diagram of another embodiment of an integrated circuit 10 that includes a die 24 and a package substrate 26. In this embodiment, the die 24 supports the circuit block 12, the MMW front-end 14, the frequency dependent impedance modules 16 and 18, the first and second trace sections 20 and 22, and a ground plane 40. In this embodiment, the trace section 20 may function as a monopole antenna with respect to the ground plane for the MMW front-end 14.

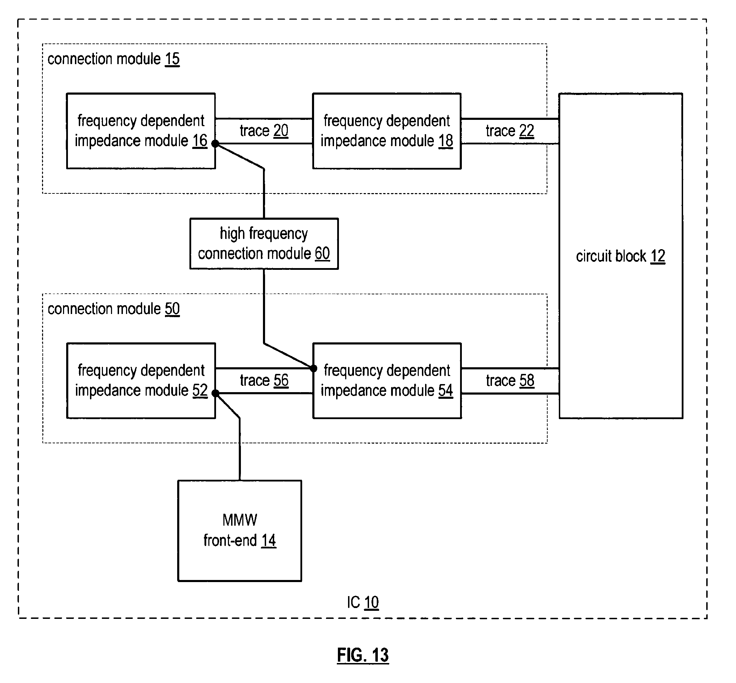

Figure 13 is a schematic block diagram of another embodiment of an integrated circuit 10 that includes the circuit block 12, the millimeter wave (MMW) front-end 14, the first connection module 15, a second connection module 50, and a high frequency connection module 60. The first connection module 15 includes the first and second frequency dependent impedance modules 16 and 18 and the first and second trace sections 20 and 22. The second connection module 50 includes third and fourth frequency dependent impedance modules 52 and 54 and the third and fourth trace sections 56 and 58. The components of the second frequency dependent impedance module 50 may be similar to the components of the first frequency dependent impedance module 16.

In this embodiment, the first trace section 20 provides an antenna segment for the MMW front-end and the third trace section 56 provides a second antenna segment for the MMW front-end. The series combination of the first and second frequency dependent impedance modules 16 and 18 and the first and second trace sections 20 and 22 provides a first connection for the circuit block 12. In addition, the series combination of the third and fourth frequency dependent impedance modules 52 and 54 and the third and fourth trace sections 56 and 58 provides a second connection for the circuit block 12. The first and second connections may be power supply and/or power supply return connections and/or signal connections.

The high frequency connecting module 60 couples the first trace section 20 to the third trace section 56 to provide an antenna for the MMW front-end 14. The series combination of the first and third trace sections 20 and 56 with the high frequency connecting module 60 is tuned such that it collective impedance substantially provides a desired impedance for the antenna at the frequency range of signals received and/or transmitted by the MMW front-end 14. Further, the high frequency connecting module 60 has a low impedance at frequencies of signals transmitted and/or received by the MMW front-end and has a high impedance on signals received by or transmitted from the signal block 12 such that the high frequency connection module 50 has little or no attenuation effect on such signals.

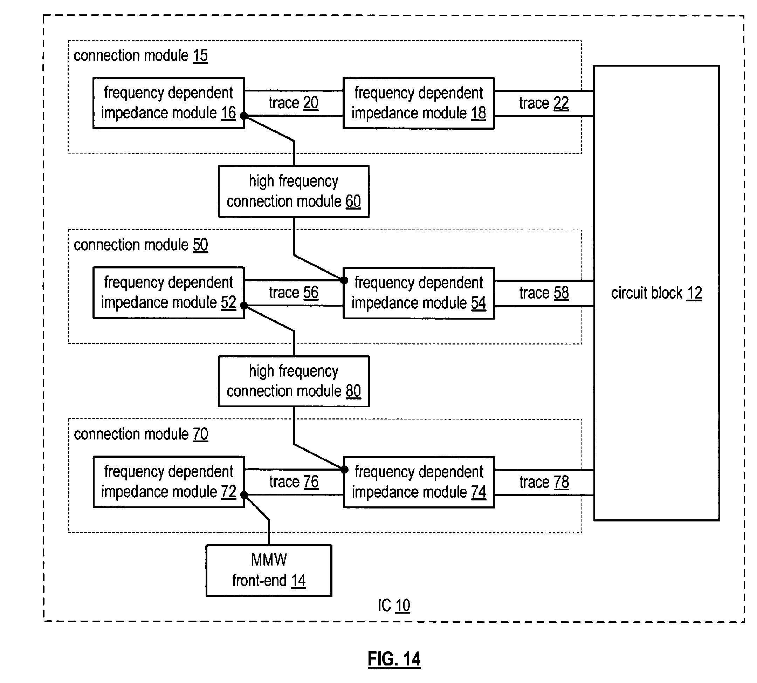

Figure 14 is a schematic block diagram of another embodiment of an integrated circuit 10 that includes the circuit block 12, the millimeter wave (MMW) front-end 14, the first connection module 15, a second connection module 50, a third connection module 70, the high frequency connection module 60, and a second high frequency connection module 80. The first connection module 15 includes the first and second frequency dependent impedance modules 16 and 18 and the first and second trace sections 20 and 22. The second connection module 50 includes third and fourth frequency dependent impedance modules 52 and 54 and the third and fourth trace sections 56 and 58. The third connection module 70 includes fifth and sixth frequency dependent impedance modules 72 and 74 and the fifth and sixth trace sections 76 and 78. The components of the third frequency dependent impedance module 70 may be similar to the components of the first frequency dependent impedance module 16.

In this embodiment, the first trace section 20, the third trace section 56, and the fifth trace section 56 provide antenna segments for the MMW front-end. In addition, the series combination of the fifth and sixth frequency dependent impedance modules 72 and 74 and the fifth and sixth trace sections 76 and 78 provides a third connection for the circuit block 12.

The high frequency connecting module 60 couples the first trace section 20 to the third trace section 56 and the second high frequency connection module 80 couples the third trace section 56 to the fifth trace section 76 to provide an antenna for the MMW front-end 14. The series combination of the trace sections 20, 56, and 76 with the high frequency connecting modules 60 and 80 is tuned such that it collective impedance substantially provides a desired impedance for the antenna at the frequency range of signals received and/or transmitted by the MMW front-end 14. Further, each of the high frequency connecting modules 60 and has a low impedance at frequencies of signals transmitted and/or received by the MMW front-end and has a high impedance on signals received by or transmitted from the signal block 12 such that the high frequency connection module 50 has little or no attenuation effect on such signals.

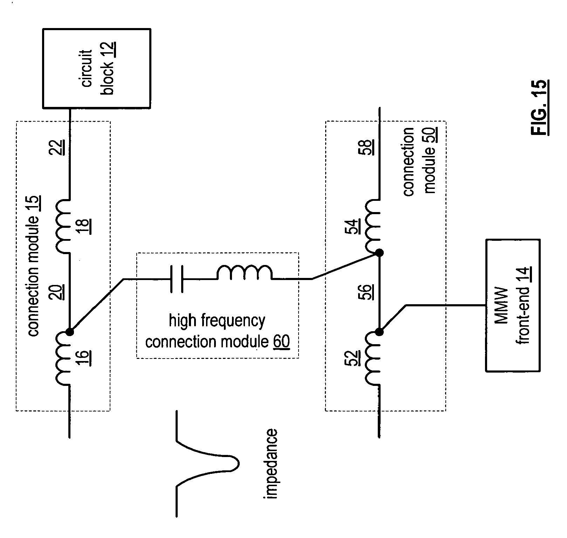

Figure 15 is a schematic block diagram of an embodiment of two connection modules 15 and 50 and an embodiment of a high frequency connection module 60. The frequency dependent connection modules 16, 18, 52, and 54 may be implemented using inductors. In this embodiment, the high frequency connection module 60 is implemented via a series inductor-capacitor (LC) tank circuit, which has a general impedance as shown. The LC tank circuit resonates at the frequencies of the signals transmitted and/or received by the MMW front-end 14 to provide a low impedance path between the two trace sections 20 and 56. In an alternate embodiment, the high frequency connection module 60 may be implemented via a capacitor.

Figure 16 is a schematic block diagram of an embodiment of coupling a connection module 50 to a MMW front-end 14 via a transformer 90 and a transmission line 92. As shown, the connection module 50 includes inductors as the frequency dependent impedance modules 52 and 54 and the trace section 56 functions as the antenna for the MMW front-end 14. Typically, the antenna will have a desired impedance (e.g., 50 Ohms) within the desired operating range (e.g., 60 GHz frequency band). As such, impedance of the transmission line 92 and output impedance of the transformer 90 should substantially equal that of the antenna.

Figure 17 is a diagram of another embodiment of coupling a connection module to a MMW front-end (not shown) via a transformer 94 and a transmission line 96. In this embodiment, the connection module is shown to include four trace sections and three inductors 34, 16, and 18. The two middle trace sections are coupled to the transmission line and provide a dipole antenna for the MMW front-end. The transformer is implemented as a differential to single-end transformer balun using a microstrip structure. As such, the differential side includes three taps: two for the differential input and the center one for a DC or AC ground connection. The two differential inputs of the transformer are connected to the MMW front-end 14.

The inductors 16, 18, and 34 of the connection module are shown as a single winding coil. Depending on the desired inductance, each inductor may be implemented as single winding coil as shown, as a spiral winding (not shown), and/or as a series of single winding coils coupled in series. In addition, the diameter of the inductors 16, 18, and 34 may vary with respect to the length of the trace section depending on the desired inductance. Further, the length of the middle traces is approximately equal to ¼ wavelength of the signals transmitted and/or received by the MMW front-end. For example, if the MMW front-end transmits and/or receives signals in the 60 GHz frequency range, then a quarter wavelength equals 1.25 mm (e.g., 0.25*C/60x10⁹, where C is the speed of light).

In the present figure, the transformer 94, transmission line 96, and the connection module are shown as being implemented on one metal layer of the IC 10. As will be appreciated, the embodiment of Figure 17 may be implemented on one or more metal layers of the IC 10.

Figure 18 is a schematic block diagram of another embodiment of coupling a connection module 50 to a MMW front-end 14 via a transformer 90, an impedance matching circuit 100, and a transmission line 92. As shown, the connection module 50 includes inductors as the frequency dependent impedance modules 52 and 54 and the trace section 56 functions as the antenna for the MMW front-end 14. Typically, the antenna will have a desired impedance (e.g., 50 Ohms) within the desired operating range (e.g., 60 GHz frequency band). As such, impedance of the transmission line 92, the impedance matching circuit 100 and output impedance of the transformer 90 should substantially equal that of the antenna.

In an embodiment, the impedance matching circuit 100 includes series inductors coupling the transformer 90 to the transmission line 92. In another embodiment, the impedance matching circuit 100 includes the series inductors and a capacitor coupled in parallel with the input of the transmission line 92.

While various embodiments of the connection modules and high frequency connection modules have been provided, other embodiments are conceivable. For example, the modules may be implemented with more complex circuitry to achieve the desired frequency characteristics. For instance, low pass filters, bandpass filters, high pass filters, and/or notch filters may be used to provide the high frequency isolation and low frequency signal passing.

As may be used herein, the terms "substantially" and "approximately" provides an industry-accepted tolerance for its corresponding term and/or relativity between items. Such an industry-accepted tolerance ranges from less than one percent to fifty percent and corresponds to, but is not limited to, component values, integrated circuit process variations, temperature variations, rise and fall times, and/or thermal noise. Such relativity between items ranges from a difference of a few percent to magnitude differences. As may also be used herein, the term(s) "coupled to" and/or "coupling" and/or includes direct coupling between items and/or indirect coupling between items via an intervening item (e.g., an item includes, but is not limited to, a component, an element, a circuit, and/or a module) where, for indirect coupling, the intervening item does not modify the information of a signal but may adjust its current level, voltage level, and/or power level. As may further be used herein, inferred coupling (i.e., where one element is coupled to another element by inference) includes direct and indirect coupling between two items in the same manner as "coupled to". As may even further be used herein, the term "operable to" indicates that an item includes one or more of power connections, input(s), output(s), etc., to perform one or more its corresponding functions and may further include inferred coupling to one or more other items. As may still further be used herein, the term "associated with", includes direct and/or indirect coupling of separate items and/or one item being embedded within another item. As may be used herein, the term "compares favorably", indicates that a comparison between two or more items, signals, etc., provides a desired relationship. For example, when the desired relationship is that signal 1 has a greater magnitude than signal 2, a favorable comparison may be achieved when the magnitude of signal 1 is greater than that of signal 2 or when the magnitude of signal 2 is less than that of signal 1.

The present invention has also been described above with the aid of method steps illustrating the performance of specified functions and relationships thereof. The boundaries and sequence of these functional building blocks and method steps have been arbitrarily defined herein for convenience of description. Alternate boundaries and sequences can be defined so long as the specified functions and relationships are appropriately performed. Any such alternate boundaries or sequences are thus within the scope and spirit of the claimed invention.

The present invention has been described above with the aid of functional building blocks illustrating the performance of certain significant functions. The boundaries of these functional building blocks have been arbitrarily defined for convenience of description. Alternate boundaries could be defined as long as the certain significant functions are appropriately performed. Similarly, flow diagram blocks may also have been arbitrarily defined herein to illustrate certain significant functionality. To the extent used, the flow diagram block boundaries and sequence could have been defined otherwise and still perform the certain significant functionality. Such alternate definitions of both functional building blocks and flow diagram blocks and sequences are thus within the scope and spirit of the claimed invention. One of average skill in the art will also recognize that the functional building blocks, and other illustrative blocks, modules and components herein, can be implemented as illustrated or by discrete components, application specific integrated circuits, processors executing appropriate software and the like or any combination thereof.

## Claims

1. An integrated circuit (IC) comprises:
a circuit block;
a millimeter wave (MMW) front-end; and
a connection module coupled to the circuit block and to the MMW front-end, wherein the connection module includes:
a first frequency dependent impedance module;
a second frequency dependent impedance module;
a first trace section coupled between the first and second frequency dependent impedance modules, wherein the first trace section provides an antenna segment for the MMW front-end; and
a second trace section coupled between the second frequency dependent impedance module and the circuit block, wherein a series combination of the first and second frequency dependent impedance modules and the first and second trace sections provides a connection for the circuit block.

2. The IC of claim 1 further comprises:
a die, wherein the circuit block, the MMW front-end, and the connection module are implemented on the die.

3. The IC of claim 1 further comprises:
a die, wherein the circuit block and the MMW front-end are implemented on the die; and
a package substrate that supports the die, wherein a portion of the connection module is implemented on the package substrate and a remaining portion of the connection module is implemented on the die.

4. The IC of claim 1 further comprises:
a second circuit block, wherein the connection module couples the circuit block to the second circuit block.

5. The IC of claim 1, wherein the circuit block is operable to receive or transmit a data signal via the connection module.

6. An integrated circuit (IC) comprises:
a circuit block;
a millimeter wave (MMW) front-end;
a first connection module including:
a first frequency dependent impedance module;
a second frequency dependent impedance module;
a first trace section coupled between the first and second frequency dependent impedance modules, wherein the first trace section provides an antenna segment for the MMW front-end; and
a second trace section coupled between the second frequency dependent impedance module and the circuit block, wherein the series combination of the first and second frequency dependent impedance modules and the first and second trace sections provides a first connection for the circuit block; and
a second connection module including:
a third frequency dependent impedance module;
a fourth frequency dependent impedance module;
a third trace section coupled between the third and fourth frequency dependent impedance modules, wherein the third trace section provides a second antenna segment for the MMW front-end; and
a fourth trace section coupled between the fourth frequency dependent impedance module and the circuit block, wherein the series combination of the third and
fourth frequency dependent impedance modules and the third and fourth trace
sections provides a second connection for the circuit block; and a high frequency connecting module coupled to the first trace section and the third trace section such that the first and second antenna segments are operably connected together in a frequency range corresponding to an operational frequency of the MMW front-end.

7. The IC of claim 6, wherein the high frequency connection module comprises:
a series inductor-capacitor tank circuit.

8. The IC of claim 6 further comprises:
a third connection module including:
a fifth frequency dependent impedance module;
a sixth frequency dependent impedance module;
a fifth trace section coupled between the fifth and sixth frequency dependent impedance modules, wherein the fifth trace section provides a third antenna segment for the MMW front-end; and
a sixth trace section coupled between the sixth frequency dependent impedance module and the circuit block, wherein the series combination of the fifth and sixth frequency dependent impedance modules and the fifth and sixth trace sections provides a third connection for the circuit block; and
a second high frequency connecting module coupled to the third trace section and the fifth trace section such that the first, second, and third antenna segments are operably connected together in a frequency range corresponding to an operational frequency of the MMW front-end.

9. An integrated circuit (IC) comprises:
a plurality of frequency dependent impedance modules; and
a plurality of trace sections, wherein a first trace section of the plurality of trace sections is coupled between a first and a second frequency dependent impedance module of the plurality of frequency dependent impedance modules, wherein the first trace section provides an antenna segment; and
wherein a second trace section of the plurality of trace sections is coupled to the second frequency dependent impedance module, wherein a series combination of the first and
second frequency dependent impedance modules and the first and second trace sections provides a connection.

10. The IC of claim 9 further comprises:
a third trace section of the plurality of trace sections is coupled between the second and a third frequency dependent impedance module of the plurality of frequency dependent impedance modules, wherein the third trace section provides a second antenna segment; and a fourth trace section of the plurality of trace sections is coupled to the third frequency dependent impedance module, wherein a series combination of the first, second, and third frequency dependent impedance modules and the first, second, third, and fourth trace sections provides the connection.
